# EUROPEAN PATENT SPECIFICATION

(11) **EP 4 597 141 B1**
(45) Date of publication and mention of the grant of the patent: **09.09.2026**
(21) Application number: 25155498.6
(22) Date of filing: 03.02.2025
(51) Int. Cl.: G01R 33/26

(54) **DOUBLE BEAM OPTICALLY PUMPED MAGNETOMETER**
OPTISCH GEPUMPTES DOPPELSTRAHL-MAGNETOMETER
MAGNÉTOMÈTRE À POMPAGE OPTIQUE À DOUBLE FAISCEAU

(30) Priority: 05.02.2024 IL 31065924
(43) Date of publication of application: 06.08.2025
(73) Proprietor: Elta Systems Ltd., Ashdod 7710201 (IL)
(72) Inventor: SHCHERBACK, Igor, 8425637 Beer Sheva (IL); ROSENZWEIG, Yossi, 7710201 Ashdod (IL); TOKAR, Dmitriy, 8425804 Beer Sheva (IL)
(74) Representative: Bianchetti & Minoja with Trevisan & Cuonzo IPS SRL

(56) References cited:
- US-B1- 10 274 549
- YOSSI ROSENZWEIG ET AL: "Heading Error Compensation in a Portable Optical Magnetometer Using a Double-Pass Single Beam Configuration", ARXIV.ORG, CORNELL UNIVERSITY LIBRARY, 201 OLIN LIBRARY CORNELL UNIVERSITY ITHACA, NY 14853, 26 July 2023 (2023-07-26), XP091575351
- OELSNER GREGOR ET AL: "Performance analysis of an optically pumped magnetometer in Earth's magnetic field", vol. 6, no. 1, 12 December 2019 (2019-12-12), pages 1 - 14, XP093254985, ISSN: 2662-4400, Retrieved from the Internet <URL:http://link.springer.com/article/10.1140/epjqt/s40507-019-0076-9/fulltext.html> [retrieved on 20250612], DOI: 10.1140/epjqt/s40507-019-0076-9
- ZHANG RUI ET AL: "Heading-Error-Free Optical Atomic Magnetometry in the Earth-Field Range", PHYSICAL REVIEW LETTERS, vol. 130, no. 15, 12 April 2023 (2023-04-12), US, pages 153601 - 1, XP093254975, ISSN: 0031-9007, DOI: 10.1103/PhysRevLett.130.153601
- YUE CHANG ET AL: "Nuclear Zeeman Effect on Heading Errors and the Suppression in Atomic Magnetometers", ARXIV.ORG, CORNELL UNIVERSITY LIBRARY, 201 OLIN LIBRARY CORNELL UNIVERSITY ITHACA, NY 14853, 18 December 2021 (2021-12-18), XP091108041

## Description

### TECHNOLOGICAL FIELD

The present disclosure, in some embodiments, thereof, relates to optically pumped magnetometers (OPMs) and, more particularly, but not exclusively, to double or split beam OPMs.

### BACKGROUND ART

"Heading Error Compensation in a Portable Optical Magnetometer Using a Double-Pass Single Beam Configuration" ARXIV. ORG, CORNELL UNIVERSITY LIBRARY, 201 OLIN LIBRARY CORNELL UNIVERSITY ITHACA, NY 14853, 26 July 2023 (2023-07-26) to YOSSI ROSENZWEIG ET AL, describes:

*"Optically pumped magnetometers are ultra-sensitive devices, but this sensitivity can significantly degrade due to heading errors, whereby a change in the angle between the pumping laser and the magnetic field translates to a change in the magnetic field readout. We present a portable all-optical single-beam magnetometer with a reduced heading error due to a double-pass configuration. We analyze it both theoretically and experimentally. In addition to this significant improvement in performance, the increased interaction length of the laser with the cell enhances the signal. Overall, the new configuration enables better accuracy, as well as the reduction of the cell temperature, laser power, and further miniaturization of the sensing head. This work opens the door for a simple and robust sub-p Tportable sensor in Earth field."*

"Performance analysis of an optically pumped magnetometer in Earth's magnetic field", EPJ Quantum Technology, vol. 6, no. 1, 12 December 2019 (2019-12-12), pages 1-14, , ISSN: 2662-4400, DOI: 10.1140/epjqt/s40507-019-0076-9 to Oelsner Gregor ET AL: describes:
*"We experimentally investigate the influence of the orientation of optically pumped magnetometers in Earth's magnetic field. Wefocus our analysis to an operational mode that promises femtotesla field resolutions at such field strengths. For this so-called light-shift dispersed Mz(LSD-Mz) regime, we focus on the key parameters defining its performance. That are the reconstructed Larmor frequency, the transfer function between output signal and magnetic field amplitude as well as the shot noise limited field resolution. We demonstrate that due to the use of two well balanced laser beams for optical pumping with different helicities the heading error as well as the field sensitivity of a detector both are only weakly influenced by the heading in a large orientation angle range."*

Acknowledgement of the above references herein is not to be inferred as meaning that these are in any way relevant to the patentability of the presently disclosed subject matter.

### GENERAL DESCRIPTION

The invention concerns a magnetic field strength measurement system in accordance with claim 1. A corresponding method of measuring magnetic field strength is defined in claim 15. Preferred embodiments are set out in the dependent claims.

Unless otherwise defined, all technical and/or scientific terms used within this document have meaning as commonly understood by one of ordinary skill in the art/s to which the present disclosure pertains. Methods and/or materials similar or equivalent to those described herein can be used in the practice and/or testing of embodiments of the present disclosure, and exemplary methods and/or materials are described below. Regarding exemplary embodiments described below, the materials, methods, and examples are illustrative and are not intended to be necessarily limiting.

Some embodiments of the present disclosure are embodied as a system, method, or computer program product. For example, some embodiments of the present disclosure may take the form of an entirely hardware embodiment, an entirely software embodiment (including firmware, resident software, micro code, etc.) or an embodiment combining software and hardware aspects that may all generally be referred to herein as a "circuit," "module" and/or "system."

Implementation of the method and/or system of some embodiments of the present disclosure can involve performing and/or completing selected tasks manually, automatically, or a combination thereof. According to actual instrumentation and/or equipment of some embodiments of the method and/or system of the present disclosure, several selected tasks could be implemented by hardware, by software or by firmware and/or by a combination thereof, e.g., using an operating system.

For example, hardware for performing selected tasks according to some embodiments of the present disclosure could be implemented as a chip or a circuit. As software, selected tasks according to some embodiments of the present disclosure could be implemented as a plurality of software instructions being executed by a computational device e.g., using any suitable operating system.

**In** some embodiments, one or more tasks according to some exemplary embodiments of method and/or system as described herein are performed by a data processor, such as a computing platform for executing a plurality of instructions. Optionally, the data processor includes a volatile memory for storing instructions and/or data and/or a non-volatile storage e.g., for storing instructions and/or data. Optionally, a network connection is provided as well. User interface/s e.g., display/s and/or user input device/s are optionally provided.

Some embodiments of the present disclosure may be described below with reference to flowchart illustrations and/or block diagrams. For example illustrating exemplary methods and/or apparatus (systems) and/or and computer program products according to embodiments of the present disclosure. It will be understood that each step of the flowchart illustrations and/or block of the block diagrams, and/or combinations of steps in the flowchart illustrations and/or blocks in the block diagrams, can be implemented by computer program instructions. These computer program instructions may be provided to a processor of a general-purpose computer, special purpose computer, or other programmable data processing apparatus to produce a machine, such that the instructions, which execute via the processor of the computer or other programmable data processing apparatus, create means for implementing the functions/acts specified in the flowchart steps and/or block diagram block or blocks.

These computer program instructions may also be stored in a computer readable medium that can direct a computer (e.g., in a memory, local and/or hosted at the cloud), other programmable data processing apparatus, or other devices to function in a particular manner, such that the instructions stored in the computer readable medium can be used to produce an article of manufacture including instructions which implement the function/act specified in the flowchart and/or block diagram block or blocks.

The computer program instructions may also be run by one or more computational device to cause a series of operational steps to be performed e.g., on the computational device, other programmable apparatus and/or other devices to produce a computer implemented process such that the instructions which execute provide processes for implementing the functions/acts specified in the flowchart and/or block diagram block or blocks.

Some of the methods described herein are generally designed only for use by a computer, and may not be feasible and/or practical for performing purely manually, by a human expert. A human expert who wanted to manually perform similar tasks, might be expected to use different methods, e.g., making use of expert knowledge and/or the pattern recognition capabilities of the human brain, potentially more efficient than manually going through the steps of the methods described herein.

### BRIEF DESCRIPTION OF THE DRAWINGS

In order to better understand the subject matter that is disclosed herein and to exemplify how it may be carried out in practice, embodiments will now be described, by way of non-limiting example only, with reference to the accompanying drawings, in which:
FIG. 1A is a simplified schematic block diagram of a magnetometer system, according to some embodiments of the disclosure;
FIG. 1B is a cross sectional view of a portion of a retroflection unit, according to some embodiments of the disclosure;
FIG. 2 is a plot of theoretical magnetic resonance frequency with angle, according to some embodiments of the disclosure;
FIG. 3 is a method of measuring a magnetic field, according to some embodiments of the disclosure;
FIG. 4 is a simplified schematic of a magnetometer system, according to some embodiments of the disclosure;
FIG. 5 is a simplified schematic of a magnetometer system, according to some embodiments of the disclosure; and
FIG. 6 is a flow chart of a method of magnetic measurement, according to some embodiments of the disclosure.

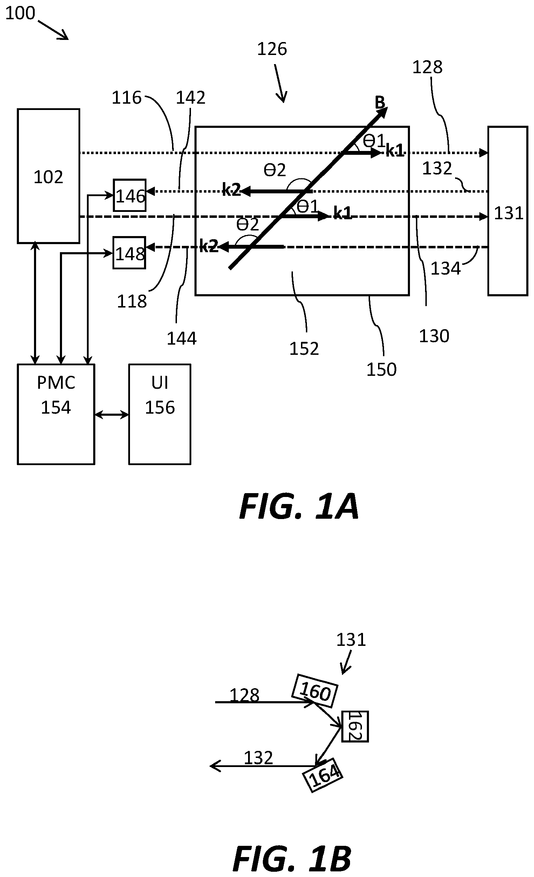

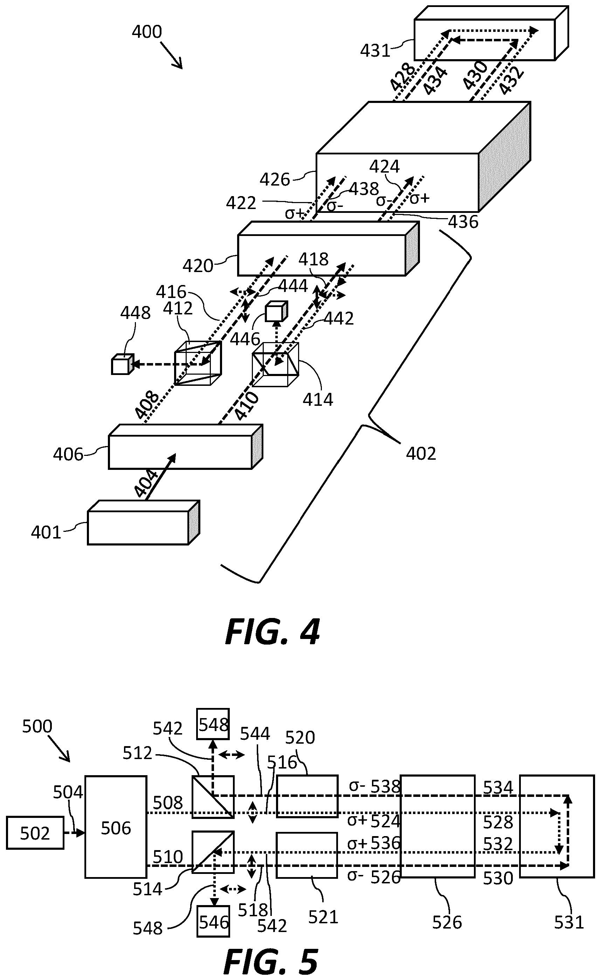

In some embodiments, although non-limiting, in different figures, like numerals are used to refer to like elements, for example, element **126** in FIG. 1A corresponding to element **426** in FIG. 4.

### DETAILED DESCRIPTION OF EMBODIMENTS

The present disclosure, in some embodiments, thereof, relates to optically pumped magnetometers (OPMs) and, more particularly, but not exclusively, to double or split beam OPMs.

### Overview

An aspect of some embodiments of the disclosure relates to optically pumped magnetometers (OPMs) and/or magnetic measurement systems where two beams of light, having opposite circular polarization are supplied to and traverse twice a transparent (e.g., glass) cell containing alkali metal vapor (herein termed a "vapor chamber" or a "vapor cell"). Where each beam, after traversing the vapor chamber in a "first pass" is returned to traverse the vapor chamber in an opposite direction, but while maintaining the same circular polarization, as a "second pass". In some embodiments, effect on light output from the vapor chamber associated with each light beam (both first and second passes of the light beam) is measured. Where, in some embodiments, the measurements of the two beams are combined, the combined measurements then being used to determine a magnetic field. A potential benefit of this double beam, double pass scenario being reduction of heading error. Where heading error is defined, for example, as a change in magnetic field measurements of the magnetometer with change in angle between a direction of laser propagation through the vapor chamber and a direction of the magnetic field being measured. For example, where the magnetic field remains the same but an orientation of the magnetometer changes in space, without changing position (e.g. coordinates in space) of the magnetometer (e.g. rotation of the magnetometer about its center). For example, where the magnetic field changes direction, with respect to the magnetometer, without changing in magnitude.

A potential benefit of two passages of light through the vapor chamber, the first pass beam and second pass beam having the same polarization but different directions, is reduction in heading error when magnetic field is determined using measurement/s of light associated with both passes.

Without wanting to be bound by theory, it is theorized that passing a same helicity circular polarization beam twice in two directions through a vapor chamber compensates for non-linearity of Zeeman splitting. For example, compensating for differences in population distribution of Zeeman states associated with different angles between the laser propagation vector and magnetic field direction vector. As the population distribution changes, it is theorized, are opposite for the first and second pass beams, heading errors of the source beam and returning beam potentially cancel each other.

However, the first pass beams are expected to experience loss/es during passage through the vapor chamber and/or during interaction between optical elements as the transmitted first pass beam is directed backward as the reflected beam to become the second pass beam. The losses meaning, potentially, that for a single double pass beam, canceling of heading errors is limited.

An aspect of some embodiments of the disclosure relates to combining measurements of two beams each having first and second passes, where, for both beams, losses between each first pass beam and each second pass beam are associated with similar optical paths (e.g., interaction with the same vapor chamber and/or optical element/s). In some embodiments, given the helicities of the beams are opposite, the remaining heading error associated with attenuation of second pass beams is theorized to be similar but opposite, combination of measurements of the two beams, each having first and second passes, potentially having a further reduced heading error.

In some embodiments, open-loop measurements are performed where a modulation signal which is scanned through a range of modulation frequencies, modulates both the first and second beams. A demodulated measurement signal (as described hereinbelow) then displays a magnetic resonance frequency from which a magnetic field measurement may be determined.

In some embodiments, measurement of the two beams is separate where, for example, the first beam is measured by a first detector and the second beam is measured by a second detector. These measurements may then be combined prior to or after demodulation.

For example, in some embodiments, first and second measurement signals are subtracted from each other (e.g., at a differential amplifier) to provide a combined measurement signal which is then demodulated (e.g., by a lock-in amplifier receiving the modulation signal and the combined measurement signal). Magnetic resonance frequency may then be extracted from the demodulated combined measurement signal.

For example, in some embodiments, first and second measurement signals are individually demodulated, e.g., each by an associated lock-in amplifier, to produce a first and a second demodulated measurement signal. Where, in some embodiments, the first and second demodulated measurement signals are combined (e.g., by subtraction or addition) to provide a demodulated combined measurement signal. Magnetic resonance frequency is then, in some embodiments, extracted from the demodulated combined measurement signal. Alternatively, or additionally, in some embodiments, magnetic resonance frequencies are extracted from the first and second demodulated measurement signals respectively, and then combined to provide a single magnetic resonance frequency.

In some embodiments, the first and second beams are combined optically and measured at a single detector. A single combined measurement signal provided by the detector, in some embodiments, is then demodulated to provide a demodulated combined measurement signal, from which a magnetic resonance frequency may be extracted.

In some embodiments, closed loop measurements are performed, the magnetic resonance frequency is extracted from (e.g., as) a frequency of the modulation signal. Where controlling the modulation frequency and feedback of the combined demodulated measurement signal are used to maintain the combined demodulated measurement signal at a set value, the modulation frequency then providing an indication of the resonance frequency. The combined magnetic resonance frequency is obtained, in some embodiments, by using a combined demodulated measurement signal (e.g., according to one of the options described hereinabove) as feedback.

In some embodiments, the magnetometer (and/or magnetic measurement system) includes a single beam for both pumping and probing of the atoms in the vapor chamber.

Alternatively, in some embodiments, a first laser beam pumps the vapor chamber and a second laser beam, a "probe beam" is passed twice through the vapor chamber (e.g. a transmitted probe beam being reflected back into the vapor chamber).

In some embodiments, a light source unit is configured to provide two circularly polarized light beams having opposite circular polarization, where the light source unit is positioned on a first side of the vapor cell, and a retroflection unit is positioned on a second side of the cell. Where element/s of the retroreflection unit are aligned to reflect the source beams emitted from the vapor cell (the transmitted beams) to the vapor cell as second pass beams.

Where, in some embodiments, the retroflection unit comprises one or more optical elements configured to reverse a received beam direction while maintaining the beam's polarization, for example, the second pass beam, having a reversed direction to that of the first pass beam and circular polarization of the same helicity as the first pass beam. For example, where the k-vectors of the entering and reflected beams have opposite sign and where the entering and reflected beams have the same helicity e.g. both left-handed circular polarization, or both right-handed circular polarization. Where, in some embodiments, the light source unit e.g. including a linearly polarized laser source and optical element/s configured to convert the linearly polarized light into circularly polarized light.

A potential advantage of the double-pass configuration is, for a given optical pathway length within the vapor chamber, increased signal amplitude potentially providing higher signal to noise ratio (SNR) for the magnetic field measurement. For example, in comparison to a single pass configuration.

Increased SNR for given optical pathway length within the vapor chamber potentially allows reduction in size of the vapor chamber increased portability. Potentially, increased SNR enables one or more of reduction of the vapor chamber temperature and reduction of laser power of the source beam.

Before explaining at least one embodiment of the invention in detail, it is to be understood that the invention is not necessarily limited in its application to the details of construction and the arrangement of the components and/or methods set forth in the following description and/or illustrated in the drawings and/or the Examples. The invention is capable of other embodiments or of being practiced or carried out in various ways.

### Exemplary system

FIG. 1A is a simplified schematic block diagram of a magnetometer system **100,** according to some embodiments of the disclosure.

In some magnetometer system **100** (herein also termed "magnetometer" or "system") includes a light source unit **102** configured to produce a first beam **116** and a second beam **118** of laser light, beams **116, 118** having opposite circular polarizations e.g. beam **116** being right-hand circularly polarized and beam **118** being left-hand circularly polarized. Where, in some embodiments light source unit **102** includes one or more feature of light source unit **402** FIG. 4.

In some embodiments, system **100** includes a vapor chamber **126** which, in some embodiments, includes a housing **150** which is formed of or includes transparent (e.g. to laser light) portion/s. Where light passing into vapor chamber **126** passes through a transparent portion of housing **150.** In some embodiments, housing **150,** holds a mixture **152** of vaporized alkali metal atoms and a buffer gas/es.

Exemplary alkali metals including any one of the Alkali metal atoms appearing in the first column of the periodic table (i.e., the Alkali metals Li, Na, K, Rb, Cs and Fr). Exemplary buffer gases include inert gasses, e.g., N₂, He, and mixtures thereof.

Magnetic field measurements, in some embodiments, are acquired by "pumping" the alkali vapor using circularly polarized laser light e.g., that emitted by source unit **102.** Where the laser light enters and interacts with material **152** within vapor chamber **126.** Pumping, it is theorized, causes the projection of the angular momentum for the alkali vapor atoms to accumulate in a "stretch state", corresponding to Zeeman level mF=F.

Once the alkali atoms are pumped, light outputted **142, 144** from vapor chamber **126** is affected by the magnetic field: alkali atoms precess, it is theorized, under a magnetic field, according to the Larmor precession frequency, which frequency is associated with the Zeeman level of the atom precessing and the magnetic field strength.

In some embodiments (for example, once vapor chamber **126** is pumped) a portion of light passing into the vapor chamber passes through the vapor chamber **126.**

In some embodiments, system **100** includes a retroflection unit **131** configured to reverse a direction of received light **128, 130,** whilst maintaining a helicity of the light **128, 130.** Where reversal in direction of first and second beam after their first pass through vapor chamber **126** directs the beams back towards vapor chamber **136** to perform a "second pass" through vapor chamber **126.** Where helicity of the light beams received **128, 130** is the same as those beams returned **132, 134** to vapor chamber **126** respectively by retroflection unit **131** e.g., if first light beam **128** has right circular polarization light, returned first light beam **132** has right circular polarization light.

Exemplary retroreflection unit **110** implementations are described with reference to FIG. 1B hereinbelow.

In some embodiments, magnetometer **100** includes at least one optical sensor (also herein termed "detector"). In some embodiments, magnetometer includes two detectors, a first detector **146** and a second detector **148.** Where detector/s **146, 148** include, in some embodiments, one or more optical sensor configured to sense light emanating from vapor chamber **126.** In some embodiments, magnetometer **100** is configured so that first detector **146** detects first beam light **142** and second detector **148** detects second beam light **144.** In embodiments including a single detector, one or more element (not illustrated) directs both light beams **142, 144** to the single detector and/or combines the two beams **142, 144** prior to detection at the signal detector.

The detector/s, for example, are configured to provide an electrical signal corresponding to received light. In some embodiments, the optical sensor/s include one or more photodiode. Where the photodiode/s are configured to output an electrical signal corresponding to light sensed by the photodiode.

To measure the magnetic field, in some embodiments, laser light beams **116, 118** are modulated, for example, by a modulation signal (e.g. provided by a current supply signal to a laser of light source unit **102).**

In some embodiments, a modulation signal is scanned through a range of frequencies (continuously or with a plurality of discrete frequency values). Where measurement signals (e.g. as provided by detectors **146, 148)** are demodulated, and a resonance frequency being extracted from the demodulated measurement signal.

Alternatively, or additionally, in some embodiments, frequency of a modulation signal is controlled using feedback of the demodulated signal, where feedback is applied to maintain the demodulated signal at a set value (e.g. zero, corresponding to zero-crossing resonance frequency of the dispersive demodulation). Where the controlled frequency of the modulation signal is interpreted as corresponding to the resonance frequency, e.g. in a steady state. When the magnetic field changes, the demodulated value changes to a higher or lower value. Then, associated with the feedback, the modulation frequency changes until the demodulated signal reaches the set value again (e.g., zero).

Modulation of the modulation signal, in some embodiments, includes frequency modulation e.g. the laser's frequency is changing with time e.g. according to a frequency of the modulation signal. In some embodiments, frequency modulation is employed when the modulation signal is directly connected to a driver of the laser.

In some embodiments, modulation of the modulation signal is via amplitude modulation e.g. where the laser amplitude is changed with time. For example, turned on and off at the modulation frequency e.g. by a chopper element which blocks the laser light on and off.

In some embodiments, modulation of the modulation signal is via polarization modulation e.g. where the laser circular polarization is changed with time. For example, switched from left to right polarization at the modulation frequency.

Illustrated in FIG. 1 are the beams **116, 118, 132, 134** passing through vapor chamber **126** and an exemplary magnetic field direction **B** where first pass beams **116, 118** have direction **k1** at an angle of θ1 to the magnetic field and second pass beams **132, 134** have direction **k2** at an angle of θ2 (i.e., *θ*₂ = *θ*₁ + 180) to the magnetic field. Heading error, e.g., as described previously, is variation of magnetic field measurements with respect to the angle of the laser beam with respect to the magnetic field to be measured **B.**

In some embodiments, magnetometer system **100** includes processing and memory circuitry (PMC) **154.** Where, in some embodiments, PMC **154** receives sensor measurement data e.g. from one or more detector/s **146, 148.** Where, in some embodiments, PMC **154** processes sensor measurements and, in some embodiments, generates control signals for elements controlled by PMC **154** e.g. light source **102.**

In some embodiments, measurement signals (e.g. provided by detectors **146, 148)** are demodulated (e.g. using the modulation signal e.g. at PMC **154)** to provide one or more demodulated measurement signal output with modulation frequency.

In some embodiments, signals from detection of beams **142, 144** are combined e.g., prior to demodulation, for example, in order to provide measurement of magnetic field with reduced heading error.

In embodiments, detection of beams **142, 144,** is separate, e.g., by first and second detectors **146, 148.** Where, in some embodiments, the signals from first and second detectors **146, 148** are subtracted from each other. Where, in some embodiments, the signals are added to each other.

In embodiments where a single detector is used to detect both beams **142, 144,** the combined detection summing the effect of beams **142, 144.**

Where, in some embodiments, demodulated measurement signals include one or more of an in-phase signal, a quadrature signal, a phase signal, and an amplitude signal. In some embodiments, demodulated measurement signal/s are generated by a lock-in amplifier (e.g. as an output thereof).

In embodiments where magnetometer **100** includes two detectors **146, 148,** in some embodiments, two lock-in amplifiers are used. Where, in some embodiments, for each lock-in amplifier, inputs include a measurement signal (from a single detector) and the modulation signal e.g., as a reference. The lock-in amplifier's output including one or more of an in-phase signals, a quadrature signal, a phase signal, and an amplitude signal. Lock-in amplifier output with modulation frequency plots are also herein termed "magnetic resonance plots" and "line-shapes". In some embodiments, the two plots, one for each detector and associated lock-in amplifier are combined (e.g., summed or subtracted from each other) and the magnetic field strength is extracted as resonance frequency/ies of the combined magnetic resonance plot.

In some embodiments, a single lock-in amplifier is used e.g., where a single detector is used, e.g., where two signals from the two detectors are combined (e.g., by a differential amplifier) prior to being fed into the lock-in amplifier. Where inputs to a single lock-in amplifier are, for example, the single detector signal or combined detector signal, and the modulation signal. Magnetic field strength may then be extracted as resonance frequency/ies of the resonance plot/s produced from the output of the single lock-in amplifier.

In some embodiments, system **100** includes one or more user interface (UI) **156.** Where, in some embodiments, UI **156** is configured to receive instruction/s and/or data (e.g. from a user) and transfer them to PMC **154.** Where, in some embodiments, UI **156** is configured to receive data from PMC **154** and, for example, display the data e.g., to user/s. The data displayed, for example, including determined measurement/s of magnetic field.

FIG. 1B is a cross sectional view of a portion of a retroflection unit **131,** according to some embodiments of the disclosure.

In some embodiments, retroreflection unit **131** includes at least two light diverting elements **160, 164** (e.g. each light diverting element including a mirror reflector or prism). Where the at least two light diverting elements have together zero relative phase retardance between S and P polarization of received light **128** with respect to the reflected light **132.** In some embodiments, retroreflection unit **131** includes one or more additional light diverting elements **162** (e.g., retroreflection unit **131,** includes at least three light diverting elements) in order to cancel out the accumulated relative phase change e.g., to maintain the relative phase between S and P polarization components.

In some embodiments, retroflection unit **131** includes a single element which is configured to retroflect without changing helicity, e.g., a single monolithic element having different portions with different optical properties.

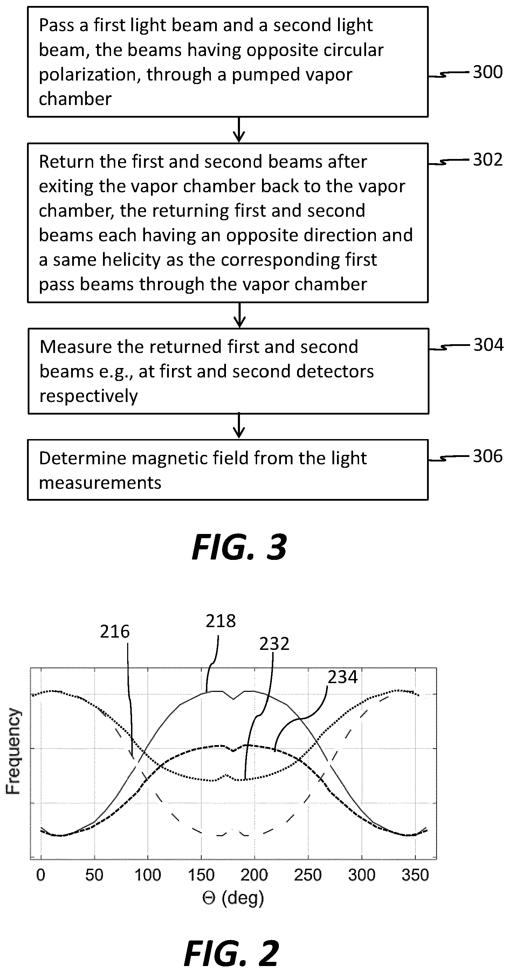

FIG. 2 is a plot of theoretical magnetic resonance frequency with angle, according to some embodiments of the disclosure.

Annotated on FIG. 2 are heading errors **216, 218, 232, 234** (e.g., differences in magnetic resonance frequency) corresponding to beam passes **116, 118, 132, 134** respectively.

Visible in FIG. 2 is how, if the overall effect of first beam (plots **216, 232)** is added to the effect of the second beam (plots **218, 234)** differences in magnetic resonance frequency are reduced (flattened) corresponding to a reduced heading error.

FIG. 3 is a method of measuring a magnetic field, according to some embodiments of the disclosure.

At **300,** in some embodiments a first light beam and a second light beam, where both light beams are circularly polarized, but with opposite helicities e.g., if first light beam is right-hand circularly polarized, then second light beam is left-hand circularly polarized.

At **302,** in some embodiments, the first and second beams are returned to the vapor chamber, after their exit from the chamber. Where the returned beams have opposite direction and the same helicity circular polarization as the beams which passed through the vapor chamber.

At **304,** in some embodiments, the returned first and second beams, after exit from the vapor chamber, are measured e.g., each by a detector.

At **306,** in some embodiments, the magnetic field is determined using the light measurements acquired at step **304,** for example, where modulation signal/s are employed e.g., as described regarding FIG. 1.

For example, where two measurement signals from two detectors (e.g., detectors **146, 148** FIG. 1) are added or subtracted from each other e.g., prior to demodulation which is performed using the modulation signal/s. Where, in some embodiments, magnetic field is extracted as a zero crossing of a line-shape.

FIG. 4 is a simplified schematic of a magnetometer system **400,** according to some embodiments of the disclosure.

In some embodiments, magnetometer system **400** (herein also termed "magnetometer" or "system") includes a light source unit **402** which includes one or more feature illustrated or described regarding light source **102** FIG. 1.

In some embodiments, light source unit **402** includes one or more of a laser **401,** an optical splitter **406,** polarization beam splitters **412, 414,** and a circular polarizer **420** (e.g., a *λ*/4 waveplate).

In some embodiments, laser **401** emits laser light **404,** laser **401,** for example, including a VCSEL laser, or DFB/DBR laser.

In some embodiments, laser **401** is configured (e.g., positioned and/or orientated) to direct emitted light **404** to optical splitter **406.** Where, in some embodiments, optical splitter **406** is configured to split received light **404** into two beams **408, 410** having a same optical power (or, where optical power of the beams differs by at most 1%).

In some embodiments, beams **408, 410** then proceed to splitters **412, 414** respectively. In some embodiments (e.g., where linear polarization of beams **408, 410** is high) splitters each include a half wave plate retarder. In some embodiments, splitters **412, 414** are polarization beam splitters (PBSs) e.g., each including a polarizer and a half wave plate. Where PBSs **412, 414,** linearly polarize beams **408, 410** to have orthogonal polarizations (e.g., as illustrated by arrows adjacent to beams **416, 418** exiting the respective PBAs **412, 414).** A first PBS **412** polarizing first beam **408,** and a second PBS **414** polarizing second beam **410.** FIG. 4 illustrates an exemplary embodiment, where the two polarizations are both orthogonal to each other and to a direction of the beams. Other orthogonal polarizations are envisioned and encompassed by the disclosure e.g., that illustrated in FIG. 5.

In some embodiments, the first and second linearly polarized beams **416, 418** pass to circular polarizer **420** which transforms the beams into circularly polarized beams **422, 424** having opposite helicity. Illustrate in FIG. 4 are helicities of an exemplary embodiment, where first circularly polarized beam **422** is right hand circularly polarized and second circularly polarized beam **424** is left hand circularly polarized.

In some embodiments, two oppositely polarized beams **422, 424** then pass to be received by vapor cell **426.** First pass beams **428, 430** (beams **422, 424** having passed through vapor cell **426)** then pass to a retroreflection unit **431,** which returns first pass beams **428, 430** to vapor cell **426** as returned beams **432, 434,** having an opposite direction but same helicity as the first pass beams **428, 430.**

Returned beams **432, 434,** after traversing vapor cell for a second time, emerge as second pass beams **436, 438** (having respectively same helicity as circularly polarized beams **422, 424** e.g., as illustrated in FIG. 4).

Second pass beams **436, 438** then pass through circular polarizer **420** to become linearly polarized second pass beams **442, 444** having orthogonal polarizations (e.g., as illustrated by arrows on the beams in FIG. 4).

Linearly polarized second pass beams **442, 444** are then directed away from a plane and/or axis of the beam travel by PBSs **412, 414** respectively to be detected by detectors **446, 448.** FIG. 4 illustrates an embodiment where second detector **448** is within an optical plane including the beam travel and other optical components whereas first detector **446** is orthogonal to the plane of first and second beams (e.g., XY plane).

In some embodiments, system includes one or both of a PMC and a UI (not illustrated in FIG. 4) each including, for example, one or more feature as illustrated in and/or described regarding PMC **154,** and UI 156 FIG. 1.

FIG. 5 is a simplified schematic of a magnetometer system **500,** according to some embodiments of the disclosure.

In some embodiments, each of a light unit **502,** a beam splitter **506,** beams **508, 510,** linearly polarized beams **516, 518,** circularly polarized beams **524, 526,** vapor chamber **526,** first pass beams **528, 530,** retroreflection unit **531,** returned beams **532, 534,** second pass beams **536, 538,** linearly polarized second pass beams **542, 544,** and detectors **546, 548,** include one or more feature as illustrated in and/or describing similarly numbered elements **402, 406, 408, 410, 426, 431** of FIG. 4.

However, in comparison to FIG. 4, FIG. 5 illustrates an exemplary embodiment where beam splitters **512, 514** and linear polarization of beams **516, 518** (e.g. as illustrated by double headed arrows) are configured so that detectors **546, 548** are both in a plane of other optical elements, a potential benefit being increased compactness of magnetometer system **500.** For beams to be correctly circularly polarized, e.g., prior to entry to vapor chamber **526,** system **500** includes two circular polarizers **520, 521.**

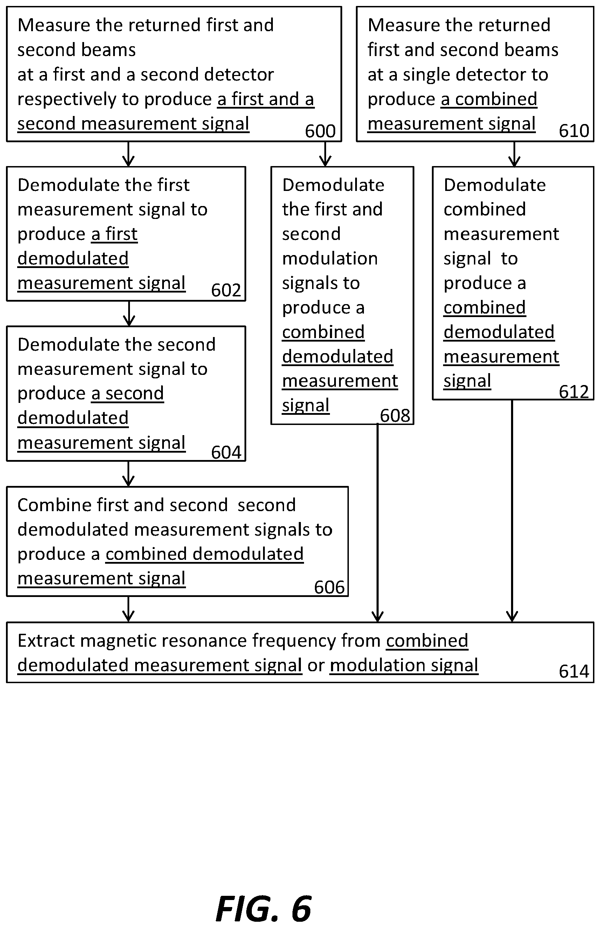

FIG. 6 is a flow chart of a method of magnetic measurement, according to some embodiments of the disclosure.

FIG. 6 illustrates exemplary options for combination of measurement of the two beams and extraction of magnetic resonance frequencies therefrom.

At **600,** in some embodiments, the returned first and second beams are measured at a first and a second detector respectively to produce a first and a second measurement signal.

At **602,** in some embodiments, the first measurement signal is demodulated to produce a first demodulated measurement signal.

At **604,** in some embodiments, the second measurement signal is demodulated to produce a second demodulated measurement signal.

At **606,** in some embodiments, the first and second demodulated measurement signals are combined (e.g., by subtraction or addition) to provide a combined demodulated measurement signal.

At **608,** in some embodiments, a magnetic resonance frequency is extracted from the combined demodulated measurement signal (or, in closed loop operation, from the frequency of the modulation signal).

In some embodiments, for example, alternatively to steps **602-606,** at **608,** in some embodiments, the first and second modulation signals are demodulated together to produce a combined demodulated measurement signal. Where, in some embodiments, the first and second measurement signals are combined prior to demodulation (for example, by subtraction of the signals from each other e.g., at a differential amplifier).

In some embodiments, alternatively to step **600,** a single detector is used to measure both first and second beams (e.g., where optical component/s are used to direct both beams to the single detector).

At step **612,** in some embodiments, the combined measurement signal produced by the single detector is then demodulated and, at step **614,** a magnetic resonance frequency is extracted.

### General

As used within this document, the term "about" refers to±20%

The terms "comprises", "comprising", "includes", "including", "having" and their conjugates mean "including but not limited to".

The term "consisting of" means "including and limited to".

As used herein, singular forms, for example, "a", "an" and "the" include plural references unless the context clearly dictates otherwise.

Within this application, various quantifications and/or expressions may include use of ranges. Range format should not be construed as an inflexible limitation on the scope of the present disclosure. Accordingly, descriptions including ranges should be considered to have specifically disclosed all the possible subranges as well as individual numerical values within that range. For example, description of a range such as from 1 to 6 should be considered to have specifically disclosed subranges such as from 1 to 3, from 1 to 4, from 1 to 5, from 2 to 4, from 2 to 6, from 3 to 6 etc., as well as individual numbers within the stated range and/or subrange, for example, 1, 2, 3, 4, 5, and 6. Whenever a numerical range is indicated within this document, it is meant to include any cited numeral (fractional or integral) within the indicated range.

It is appreciated that certain features which are (e.g., for clarity) described in the context of separate embodiments, may also be provided in combination in a single embodiment. Where various features of the present disclosure, which are (e.g., for brevity) described in a context of a single embodiment, may also be provided separately or in any suitable sub-combination or may be suitable for use with any other described embodiment. Features described in the context of various embodiments are not to be considered essential features of those embodiments, unless the embodiment is inoperative without those elements.

Although the present disclosure has been described in conjunction with specific embodiments thereof, it is evident that many alternatives, modifications, and variations will be apparent to those skilled in the art.

Where section headings are used in this document, they should not be interpreted as necessarily limiting.

## Claims

1. A magnetic field strength measurement system (100) comprising:
a vapor chamber holding alkali metal vapor (126);
a light source unit (102) configured to supply a first circularly polarized light beam (116) and a second circularly polarized light beam (118) to said vapor chamber (126), said first circularly polarized beam (116) and said second circularly polarized beam (118) having opposite circular polarization;
a retroflection unit (131) comprising at least one optical element and configured to return said first circularly polarized beam and said second circularly polarized beam to said vapor chamber (126), reversing direction, while maintaining polarization, of said first circularly polarized beam (116) and said second circularly polarized beam (118);
at least one detector configured to measure light associated with said first circularly polarized beam (116) and said second circularly polarized beam (118) emitted from said vapor chamber (126) and to produce at least one measurement signal;
circuitry configured to:
provide a modulating signal to said light source unit (102), said modulating signal configured to modulate said first circularly polarized beam (116) and said second circularly polarized second beam (118);
receive said at least one measurement signal from said at least one detector; and
demodulate the at least one measurement signal and determine a magnetic resonance frequency using the modulating signal and said at least one measurement signal either:
(i) by extraction from the demodulated measurement signal; or
(ii) by extraction from a modulation frequency of the modulating signal after feedback of the demodulated measurement signal and control of the modulation frequency to maintain the demodulated measurement signal at a set value.

2. The system according to claim 1, wherein said at least one detector comprises:
a first detector configured (146) to measure light associated with said first circularly polarized beam (116) and emitted from said vapor chamber (126) and to generate a first measurement signal; and
a second detector (148) configured to measure light associated with said second circularly polarized beam (118) and emitted from said vapor chamber (126) and to generate a second measurement signal;
wherein said system comprises circuitry configured to combine said first measurement signal and said second measurement signal.

3. The system according to claim 2, wherein said circuitry comprises a differential amplifier configured to subtract said first and said second measurement signals from each other to provide a combined measurement signal.

4. The system according to claim 2, comprising one or more optical element configured to direct said first circularly polarized beam (116) and said second circularly polarized beam (118) emitted from said vapor chamber (126) towards said at least one detector which is configured to measure light associated with said first circularly polarized beam (116) and said second circularly polarized beam (118) emitted from said vapor chamber (126) and to generate a combined measurement signal.

5. The system according to claim 4, wherein said circuitry is configured to provide said modulation signal at a plurality of modulation frequencies;
wherein said combined measurement signal comprises a plurality of amplitudes, each amplitude associated with a frequency of said plurality of modulation frequencies.

6. The system according to any one of claims 3-5, wherein said circuitry comprises a lock-in amplifier configured to receive said combined measurement signal and said modulation signal and to produce a combined demodulated measurement signal; wherein said demodulated combined measurement signal comprises a dispersive plot; and
wherein said circuitry is configured to extract said resonance frequency as a zero-crossing of said dispersive plot.

7. The system according to claim 2, comprising circuitry configured to:
demodulate said first measurement signal and said second measurement signal using said modulating signal, to provide a first demodulated measurement signal and a second demodulated measurement signal;
wherein said circuitry is configured to provide said modulation signal at a plurality of modulation frequencies;
wherein said first and said second demodulated measurement signals each comprise a plurality of amplitudes each amplitude associated with a frequency of said plurality of modulation frequencies.

8. The system according to claim 7, wherein said circuitry is configured to one or more of:
• demodulate said first measurement signal and said second measurement signal wherein said circuitry comprises:
∘ a first lock-in amplifier configured to receive said first measurement signal, said modulating signal, and configured to output said first demodulated measurement signal; and
∘ a second lock-in amplifier configured to receive said second measurement signal, said modulating signal, and configured to output said second demodulated measurement signal;
• combine said first and said second demodulated measurement signals to provide a combined demodulated measurement signal; and extract said resonance frequency from said combined demodulated measurement signal.

9. The system according to claim 8, wherein said circuitry is configured to add said first and said second demodulated measurement signals; or
to subtract said first and said second demodulated measurement signals from each other.

10. The system according to any one of claims 8-9, wherein said combined demodulated measurement signal comprises a dispersive plot and where said circuitry is configured to extract said resonance frequency as a zero-crossing of a said dispersive plot.

11. The system according to claim 6 or claim 8 or claim 10, wherein said circuitry is configured to use said combined demodulated measurement signal as feedback to said modulation signal to maintain said combined demodulated measurement signal at a set value, where said resonance frequency is extracted as a steady state frequency of said modulation signal.

12. The system according to any one of claims 2-11, wherein said light source (102) unit comprises one or more of:
• a laser light source configured to provide a laser light beam; and a beam splitter configured to produce a first and a second about equal power laser light beam;
• a first polarizing beam splitter positioned to receive said first beam and configured to output a first linearly polarized beam; and a second polarizing beam splitter positioned to receive said second beam and configured to output a second linearly polarized beam, polarization of said first and second linearly polarized beam being orthogonal; and
• at least one circular polarizer positioned to receive said first and second linearly polarized beams and configured to circularly polarize said first and second linearly polarized beams to provide said first circularly polarized beam and said second circularly polarized beam which at least one circular polarizer positioned to provide said first circularly polarized beam and said second circularly polarized beam to said vapor chamber.

13. The system according to claim 12, wherein said first (116) and said second (118) circularly polarized beams are fed to said vapor chamber (126) in a first direction and where said retroflection unit (131) is positioned to reverse a direction of said first (116) and said second (118) circularly polarized beams to provide first and second returning beams to said vapor chamber.

14. The system according to claim 13, wherein said first and said second returning beams, upon exiting said vapor chamber (126) pass through said circular polarizer to become first and second linearly polarized returning beams;
wherein said first linearly polarized returning beam is received by said second polarizing beam splitter which directs said first linearly polarized returning beam to said second detector; and
wherein said second linearly polarized returning beam is received by said first polarizing beam splitter which directs said second linearly polarized returning beam to said first detector.

15. A method of measuring magnetic field strength comprising:
providing a modulating signal;
directing a first (116) and a second (118) circularly polarized light beam into a vapor chamber (126) of pumped alkali metal atoms in a first direction, where said first (116) and said second (118) circularly polarized light beams have opposite circular polarization helicity and are modulated according to said modulating signal;
reversing a direction, while maintaining polarization, of said first and said second circularly polarized beams upon exit from said vapor chamber (126) to provide a first and second returning circularly polarized beam to said vapor chamber, said first and said second returning circularly polarized beams having opposite direction, and same circular polarization helicity as said first and said second circularly polarized beams respectively;
acquiring at least one measurement signal of:
light emitted from said vapor chamber (126) and associated with said first (116) circularly polarized beam and said first returning circularly polarized beam; and light emitted from said vapor chamber (126) and associated with said second (118) circularly polarized beam and said second returning circularly polarized beam;
demodulating the at least one measurement signal using the modulating signal to provide a demodulated measurement signal; and
determining a magnetic resonance frequency:
(i) by extraction from the demodulated measurement signal, or
(ii) by extraction from a modulation frequency of the modulating signal after feedback of the demodulated measurement signal and control of the modulation frequency to maintain the demodulated measurement signal at a set value.

## Patentansprüche

1. Magnetfeldstärkemesssystem (100), umfassend:
eine Dampfkammer, die Alkalimetalldampf (126) enthält;
eine Lichtquelleneinheit (102), die so ausgelegt ist, dass sie einen ersten zirkular polarisierten Lichtstrahl (116) und einen zweiten zirkular polarisierten Lichtstrahl (118) an die Dampfkammer (126) liefert, wobei der erste zirkular polarisierte Lichtstrahl (116) und der zweite zirkular polarisierte Lichtstrahl (118) eine entgegengesetzte Zirkularpolarisation aufweisen;
eine Retroreflektionseinheit (131), die mindestens ein optisches Element umfasst und dazu ausgelegt ist, den ersten zirkular polarisierten Strahl und den zweiten zirkular polarisierten Strahl in die Dampfkammer (126) zurückzuführen, indem die Richtung des ersten zirkular polarisierten Strahls (116) und des zweiten zirkular polarisierten Strahls (118) umgekehrt wird, während die Polarisation beibehalten wird;
mindestens einen Detektor, der dazu ausgelegt ist, Licht zu messen, das mit dem ersten zirkular polarisierten Strahl (116) und dem zweiten zirkular polarisierten Strahl (118) assoziiert ist, die von der Dampfkammer (126) emittiert werden, und mindestens ein Messsignal zu produzieren;
Schaltungsanordnung, die zu Folgendem ausgelegt ist:
Bereitstellen eines Modulationssignals an die Lichtquelleneinheit (102), wobei das Modulationssignal dazu ausgelegt ist, den ersten zirkular polarisierten Strahl (116) und den zweiten zirkular polarisierten zweiten Strahl (118) zu modulieren;
Empfangen des mindestens einen Messsignals von dem mindestens einen Detektor; und
Demodulieren des mindestens einen Messsignals und Bestimmen einer Magnetresonanzfrequenz unter Verwendung des Modulationssignals und des mindestens einen Messsignals entweder:
(i) durch Extraktion aus dem demodulierten Messsignal; oder
(ii) durch Extraktion aus einer Modulationsfrequenz des Modulationssignals nach Rückkopplung des demodulierten Messsignals und Steuern der Modulationsfrequenz, um das demodulierte Messsignal auf einem Sollwert zu halten.

2. System nach Anspruch 1, wobei der mindestens eine Detektor Folgendes umfasst:
einen ersten Detektor (146), der ausgelegt ist, um Licht zu messen, das mit dem ersten zirkular polarisierten Strahl (116) assoziiert ist und von der Dampfkammer (126) emittiert wird, und um ein erstes Messsignal zu erzeugen; und
einen zweiten Detektor (148), der ausgelegt ist, um Licht zu messen, das mit dem zweiten zirkular polarisierten Strahl (118) assoziiert ist und von der Dampfkammer (126) emittiert wird, und um ein zweites Messsignal zu erzeugen;
wobei das System eine Schaltungsanordnung umfasst, die dazu ausgelegt ist, das erste Messsignal und das zweite Messsignal zu kombinieren.

3. System nach Anspruch 2, wobei die Schaltungsanordnung einen Differenzverstärker umfasst, der dazu ausgelegt ist, das erste und das zweite Messsignal voneinander zu subtrahieren, um ein kombiniertes Messsignal bereitzustellen.

4. System nach Anspruch 2, umfassend ein oder mehrere optische Elemente, die dazu ausgelegt sind, den ersten zirkular polarisierten Strahl (116) und den zweiten zirkular polarisierten Strahl (118), die von der Dampfkammer (126) emittiert werden, zu dem mindestens einen Detektor zu lenken, der dazu ausgelegt ist, Licht zu messen, das mit dem ersten zirkular polarisierten Strahl (116) und dem zweiten zirkular polarisierten Strahl (118), die von der Dampfkammer (126) emittiert werden, assoziiert ist, und ein kombiniertes Messsignal zu erzeugen.

5. System nach Anspruch 4, wobei die Schaltungsanordnung ausgelegt ist, um das Modulationssignal bei einer Vielzahl von Modulationsfrequenzen bereitzustellen;
wobei das kombinierte Messsignal eine Vielzahl von Amplituden umfasst, wobei jede Amplitude mit einer Frequenz aus der Vielzahl von Modulationsfrequenzen assoziiert ist.

6. System nach einem der Ansprüche 3-5, wobei die Schaltungsanordnung einen Lock-in-Verstärker umfasst, der dazu ausgelegt ist, das kombinierte Messsignal und das Modulationssignal zu empfangen und ein kombiniertes demoduliertes Messsignal zu produzieren; wobei das demodulierte kombinierte Messsignal eine Dispersionskurve umfasst; und
wobei die Schaltungsanordnung dazu ausgelegt ist, die Resonanzfrequenz als einen Nulldurchgang der Dispersionskurve zu extrahieren.

7. System nach Anspruch 2, umfassend eine Schaltungsanordnung, die zu Folgendem ausgelegt ist:
Demodulieren des ersten Messsignals und des zweiten Messsignals unter Verwendung des Modulationssignals, um ein erstes demoduliertes Messsignal und ein zweites demoduliertes Messsignal bereitzustellen;
wobei die Schaltungsanordnung ausgelegt ist, um das Modulationssignal bei einer Vielzahl von Modulationsfrequenzen bereitzustellen;
wobei das erste und das zweite demodulierte Messsignal jeweils eine Vielzahl von Amplituden umfassen, wobei jede Amplitude mit einer Frequenz aus der Vielzahl von Modulationsfrequenzen assoziiert ist.

8. System nach Anspruch 7, wobei die Schaltungsanordnung zu einem oder mehreren von Folgendem ausgelegt ist:
• Demodulieren des ersten Messsignals und des zweiten Messsignals, wobei die Schaltungsanordnung Folgendes umfasst:
∘ einen ersten Lock-in-Verstärker, der dazu ausgelegt ist, das erste Messsignal, das Modulationssignal, zu empfangen und ausgelegt ist, das erste demodulierte Messsignal auszugeben; und
∘ einen zweiten Lock-in-Verstärker, der dazu ausgelegt ist, das zweite Messsignal, das Modulationssignal, zu empfangen und ausgelegt ist, das zweite demodulierte Messsignal auszugeben;
• Kombinieren des ersten und des zweiten demodulierten Messsignals, um ein kombiniertes demoduliertes Messsignal bereitzustellen; und Extrahieren der Resonanzfrequenz aus dem kombinierten demodulierten Messsignal.

9. System nach Anspruch 8, wobei die Schaltungsanordnung ausgelegt ist, um das erste und das zweite demodulierte Messsignal zu addieren; oder
um das erste und das zweite demodulierte Messsignal voneinander zu subtrahieren.

10. System nach einem der Ansprüche 8 bis 9, wobei das kombinierte, demodulierte Messsignal eine Dispersionskurve umfasst und wobei die Schaltungsanordnung dazu ausgelegt ist, die Resonanzfrequenz als einen Nulldurchgang einer Dispersionskurve zu extrahieren.

11. System nach Anspruch 6 oder Anspruch 8 oder Anspruch 10, wobei die Schaltungsanordnung dazu ausgelegt ist, das kombinierte demodulierte Messsignal als Rückkopplung zu dem Modulationssignal zu verwenden, um das kombinierte demodulierte Messsignal auf einem Sollwert zu halten, wobei die Resonanzfrequenz als eine stationäre Frequenz des Modulationssignals extrahiert wird.

12. System nach einem der Ansprüche 2-11, wobei die Lichtquelleneinheit (102) eines oder mehrere der Folgenden umfasst:
• eine Laserlichtquelle, die dazu ausgelegt ist, einen Laserlichtstrahl bereitzustellen; und einen Strahlteiler, der dazu ausgelegt ist, einen ersten und einen zweiten etwa gleich starken Laserlichtstrahl zu produzieren;
• einen ersten polarisierenden Strahlteiler, der positioniert ist, um den ersten Strahl zu empfangen, und der ausgelegt ist, um einen ersten linear polarisierten Strahl auszugeben; und einen zweiten polarisierenden Strahlteiler, der positioniert ist, um den zweiten Strahl zu empfangen, und der ausgelegt ist, um einen zweiten linear polarisierten Strahl auszugeben, wobei die Polarisation des ersten und zweiten linear polarisierten Strahls orthogonal ist; und
• mindestens einen Zirkularpolarisator, der positioniert ist, um den ersten und zweiten linear polarisierten Strahl zu empfangen, und der so ausgelegt ist, dass er den ersten und zweiten linear polarisierten Strahl zirkular polarisiert, um den ersten zirkular polarisierten Strahl und den zweiten zirkular polarisierten Strahl bereitzustellen, wobei mindestens ein Zirkularpolarisator positioniert ist, um den ersten zirkular polarisierten Strahl und den zweiten zirkular polarisierten Strahl an die Dampfkammer bereitzustellen.

13. System nach Anspruch 12, wobei der erste (116) und der zweite (118) zirkular polarisierte Strahl der Dampfkammer (126) in einer ersten Richtung zugeführt werden und wobei die Retroreflektionseinheit (131) positioniert ist, um eine Richtung des ersten (116) und des zweiten (118) zirkular polarisierten Strahls umzukehren, um einen ersten und einen zweiten zurückkehrenden Strahl an die Dampfkammer bereitzustellen.

14. System nach Anspruch 13, wobei der erste und der zweite zurückkehrende Strahl beim Verlassen der Dampfkammer (126) den Zirkularpolarisator durchlaufen, um sich in einen ersten und einen zweiten linear polarisierten zurückkehrenden Strahl zu verwandeln;
wobei der erste linear polarisierte zurückkehrende Strahl von dem zweiten polarisierenden Strahlteiler empfangen wird, der den ersten linear polarisierten zurückkehrenden Strahl zu dem zweiten Detektor lenkt; und
wobei der zweite linear polarisierte zurückkehrende Strahl von dem ersten polarisierenden Strahlteiler empfangen wird, der den zweiten linear polarisierten zurückkehrenden Strahl zu dem ersten Detektor lenkt.

15. Verfahren zur Messung der Magnetfeldstärke, umfassend:
Bereitstellen eines Modulationssignals;
Lenken eines ersten (116) und eines zweiten (118) zirkular polarisierten Lichtstrahls in eine Dampfkammer (126) aus gepumpten Alkalimetallatomen in einer ersten Richtung, wobei der erste (116) und der zweite (118) zirkular polarisierte Lichtstrahl eine entgegengesetzte Zirkularpolarisationshelizität aufweisen und gemäß dem Modulationssignal moduliert werden;
Umkehren einer Richtung, unter Beibehaltung der Polarisation, des ersten und des zweiten zirkular polarisierten Strahls beim Austreten aus der Dampfkammer (126), um einen ersten und einen zweiten zurückkehrenden zirkular polarisierten Strahl an die Dampfkammer bereitzustellen, wobei der erste und der zweite zurückkehrende zirkular polarisierte Strahl entgegengesetzte Richtungen und dieselbe Zirkularpolarisationshelizität wie der erste bzw. der zweite zirkular polarisierte Strahl aufweisen;
Erfassen mindestens eines Messsignals von:
Licht, das von der Dampfkammer (126) emittiert wird und mit dem ersten (116) zirkular polarisierten Strahl und dem ersten zurückkehrenden zirkular polarisierten Strahl assoziiert ist; und Licht, das von der Dampfkammer (126) emittiert wird und mit dem zweiten (118) zirkular polarisierten Strahl und dem zweiten zurückkehrenden zirkular polarisierten Strahl assoziiert ist;
Demodulieren des mindestens einen Messsignals unter Verwendung des Modulationssignals, um ein demoduliertes Messsignal bereitzustellen; und
Bestimmen einer Magnetresonanzfrequenz:
(i) durch Extraktion aus dem demodulierten Messsignal oder
(ii) durch Extraktion aus einer Modulationsfrequenz des Modulationssignals nach Rückkopplung des demodulierten Messsignals und Steuern der Modulationsfrequenz, um das demodulierte Messsignal auf einem Sollwert zu halten.

## Revendications

1. Système de mesure (100) de l'intensité d'un champ magnétique comprenant :
une chambre à vapeur contenant de la vapeur de métal alcalin (126) ;
une unité de source de lumière (102) configurée pour fournir un premier faisceau lumineux à polarisation circulaire (116) et un second faisceau lumineux à polarisation circulaire (118) à ladite chambre à vapeur (126), ledit premier faisceau à polarisation circulaire (116) et ledit second faisceau à polarisation circulaire (118) présentant une polarisation circulaire opposée ;
une unité de rétro-réflexion (131) comprenant au moins un élément optique et configurée pour renvoyer ledit premier faisceau à polarisation circulaire et ledit second faisceau à polarisation circulaire vers ladite chambre à vapeur (126), en inversant la direction, tout en conservant la polarisation, dudit premier faisceau à polarisation circulaire (116) et dudit second faisceau à polarisation circulaire (118) ;
au moins un détecteur configuré pour mesurer la lumière associée audit premier faisceau à polarisation circulaire (116) et audit second faisceau à polarisation circulaire (118) émis par ladite chambre à vapeur (126) et pour produire au moins un signal de mesure ;
une circuiterie conçue pour :
fournir un signal de modulation à ladite unité de source de lumière (102), ledit signal de modulation configuré pour moduler ledit premier faisceau à polarisation circulaire (116) et ledit second faisceau à polarisation circulaire (118) ;
recevoir ledit au moins un signal de mesure provenant dudit au moins un détecteur ; et
démoduler l'au moins un signal de mesure et déterminer une fréquence de résonance magnétique à l'aide du signal de modulation et dudit au moins un signal de mesure, soit :
(i) par extraction à partir du signal de mesure démodulé ; ou
(ii) par extraction d'une fréquence de modulation du signal de modulation après rétroaction du signal de mesure démodulé et commande de la fréquence de modulation afin de maintenir le signal de mesure démodulé à une valeur de consigne.

2. Système selon la revendication 1, ledit au moins un détecteur comprenant :
un premier détecteur (146) configuré pour mesurer la lumière associée audit premier faisceau à polarisation circulaire (116) et émise par ladite chambre à vapeur (126), et pour générer un premier signal de mesure ; et
un second détecteur (148) configuré pour mesurer la lumière associée audit second faisceau à polarisation circulaire (118) et émise par ladite chambre à vapeur (126), et pour générer un second signal de mesure ;
ledit système comprenant une circuiterie configurée pour combiner ledit premier signal de mesure et ledit second signal de mesure.

3. Système selon la revendication 2, ladite circuiterie comprenant un amplificateur différentiel configuré pour soustraire lesdits premier et second signaux de mesure l'un de l'autre afin de fournir un signal de mesure combiné.

4. Système selon la revendication 2, comprenant un ou plusieurs éléments optiques configurés pour diriger ledit premier faisceau à polarisation circulaire (116) et ledit second faisceau à polarisation circulaire (118) émis par ladite chambre à vapeur (126) vers ledit au moins un détecteur qui est configuré pour mesurer la lumière associée audit premier faisceau à polarisation circulaire (116) et audit second faisceau à polarisation circulaire (118) émis par ladite chambre à vapeur (126) et pour générer un signal de mesure combiné.

5. Système selon la revendication 4, ladite circuiterie étant configurée pour fournir ledit signal de modulation à une pluralité de fréquences de modulation ;
ledit signal de mesure combiné comprenant une pluralité d'amplitudes, chaque amplitude étant associée à une fréquence de ladite pluralité de fréquences de modulation.

6. Système selon l'une quelconque des revendications 3-5, ladite circuiterie comprenant un amplificateur synchrone configuré pour recevoir ledit signal de mesure combiné et ledit signal de modulation et pour produire un signal de mesure combiné démodulé ; ledit signal de mesure combiné démodulé comprenant un tracé de dispersion ; et
ladite circuiterie étant configurée pour extraire ladite fréquence de résonance en tant que passage par zéro dudit tracé de dispersion.

7. Système selon la revendication 2, comprenant une circuiterie configurée pour :
démoduler ledit premier signal de mesure et ledit second signal de mesure à l'aide dudit signal de modulation, afin d'obtenir un premier signal de mesure démodulé et un second signal de mesure démodulé ;
ladite circuiterie étant configurée pour fournir ledit signal de modulation à une pluralité de fréquences de modulation ;
lesdits premier et second signaux de mesure démodulés comprenant chacun une pluralité d'amplitudes, chaque amplitude étant associée à une fréquence de ladite pluralité de fréquences de modulation.

8. Système selon la revendication 7, ladite circuiterie étant configurée pour effectuer l'une ou plusieurs des opérations suivantes :
• démoduler ledit premier signal de mesure et ledit second signal de mesure, ladite circuiterie comprenant :
∘ un premier amplificateur synchrone, conçu pour recevoir ledit premier signal de mesure et ledit signal de modulation, et conçu pour fournir en sortie ledit premier signal de mesure démodulé ; et
∘ un second amplificateur synchrone, conçu pour recevoir ledit second signal de mesure et ledit signal de modulation, et conçu pour fournir en sortie ledit second signal de mesure démodulé ;
• combiner lesdits premier et second signaux de mesure démodulés afin d'obtenir un signal de mesure démodulé combiné ; et extraire ladite fréquence de résonance dudit signal de mesure démodulé combiné.

9. Système selon la revendication 8, ladite circuiterie étant configurée pour additionner lesdits premier et second signaux de mesure démodulés ; ou
pour soustraire lesdits premier et second signaux de mesure démodulés l'un de l'autre.

10. Système selon l'une quelconque des revendications 8-9, ledit signal de mesure démodulé combiné comprenant un tracé de dispersion et où ladite circuiterie étant configurée pour extraire ladite fréquence de résonance en tant que passage par zéro d'un dit tracé de dispersion.

11. Système selon la revendication 6 ou la revendication 8 ou la revendication 10, ladite circuiterie étant configurée pour utiliser ledit signal de mesure démodulé combiné comme rétroaction sur ledit signal de modulation afin de maintenir ledit signal de mesure démodulé combiné à une valeur de consigne, où ladite fréquence de résonance étant extraite en tant que fréquence permanente dudit signal de modulation.

12. Système selon l'une quelconque des revendications 2-11, ladite unité de source de lumière (102) comprenant un ou plusieurs des éléments suivants :
• une source de lumière laser conçue pour émettre un faisceau de lumière laser ; et un séparateur de faisceau conçu pour produire un premier et un second faisceaux de lumière laser de puissance à peu près égale ;
• un premier séparateur de faisceau polarisant, positionné de manière à recevoir ledit premier faisceau et configuré pour fournir en sortie un premier faisceau à polarisation linéaire ; et un second séparateur de faisceau polarisant, positionné de manière à recevoir ledit second faisceau et configuré pour fournir en sortie un second faisceau à polarisation linéaire, la polarisation desdits premier et second faisceaux à polarisation linéaire étant orthogonale ; et
• au moins un polariseur circulaire positionné de manière à recevoir lesdits premier et second faisceaux à polarisation linéaire et configuré pour polariser de façon circulaire lesdits premier et second faisceaux à polarisation linéaire afin de fournir ledit premier faisceau à polarisation circulaire et ledit second faisceau à polarisation circulaire, ledit au moins un polariseur circulaire étant positionné de manière à fournir ledit premier faisceau à polarisation circulaire et ledit second faisceau à polarisation circulaire vers ladite chambre à vapeur.

13. Système selon la revendication 12, lesdits premier (116) et second (118) faisceaux à polarisation circulaire étant acheminés vers ladite chambre à vapeur (126) dans une première direction et où ladite unité de rétro-réflexion (131) est positionnée de manière à inverser la direction desdits premier (116) et second (118) faisceaux à polarisation circulaire afin de fournir des premier et second faisceaux de retour à ladite chambre à vapeur.

14. Système selon la revendication 13, lesdits premier et second faisceaux de retour, à la sortie de ladite chambre à vapeur (126), traversant ledit polariseur circulaire pour devenir des premier et second faisceaux de retour à polarisation linéaire ;
ledit premier faisceau de retour à polarisation linéaire étant reçu par ledit second séparateur de faisceaux polarisant, qui dirige ledit premier faisceau de retour à polarisation linéaire vers ledit second détecteur ; et
ledit second faisceau de retour à polarisation linéaire étant reçu par ledit premier séparateur de faisceau polarisant, qui dirige ledit second faisceau de retour à polarisation linéaire vers ledit premier détecteur.

15. Procédé de mesure de l'intensité d'un champ magnétique, comprenant :
la fourniture d'un signal de modulation ;
l'orientation d'un premier (116) et d'un second (118) faisceaux lumineux à polarisation circulaire dans une chambre à vapeur (126) d'atomes de métal alcalin pompés dans une première direction, où lesdits premier (116) et second (118) faisceaux lumineux à polarisation circulaire présentent une hélicité de polarisation circulaire opposée et sont modulés selon ledit signal de modulation ;
l'inversion de la direction, tout en conservant la polarisation, desdits premier et second faisceaux à polarisation circulaire à leur sortie de ladite chambre à vapeur (126) afin de fournir un premier et un second faisceaux de retour à polarisation circulaire vers ladite chambre à vapeur, lesdits premier et second faisceaux de retour à polarisation circulaire ayant une direction opposée, et la même hélicité de polarisation circulaire, respectivement, que lesdits premier et second faisceaux à polarisation circulaire ;
l'acquisition d'au moins un signal de mesure de :
la lumière émise de ladite chambre à vapeur (126) et associée audit premier faisceau (116) à polarisation circulaire et audit premier faisceau de retour à polarisation circulaire ; et la lumière émise de ladite chambre à vapeur (126) et associée audit second faisceau (118) à polarisation circulaire et audit second faisceau de retour à polarisation circulaire ;
la démodulation de l'au moins un signal de mesure à l'aide du signal de modulation afin d'obtenir un signal de mesure démodulé ; et
la détermination d'une fréquence de résonance magnétique :
(i) par extraction à partir du signal de mesure démodulé, ou
(ii) par extraction d'une fréquence de modulation du signal de modulation après rétroaction du signal de mesure démodulé et commande de la fréquence de modulation afin de maintenir le signal de mesure démodulé à une valeur de consigne.
